# EUROPEAN PATENT SPECIFICATION

(11) **EP 2 217 441 B1**
(45) Date of publication and mention of the grant of the patent: **19.02.2020**
(21) Application number: 08861811.1
(22) Date of filing: 11.12.2008
(51) Int. Cl.: H01L 31/048, B32B 17/10, B32B 38/06

(54) **TERIONOMER FILMS OR SHEETS AND SOLAR CELL MODULES COMPRISING THE SAME**
TERIONOMERFOLIEN ODER -PLATTEN UND DIESE ENTHALTENDE SOLARZELLENMODULE
FILMS OU FEUILLES EN TERIONOMÈRE ET MODULES DE CELLULE SOLAIRE LES COMPRENANT

(30) Priority: 14.12.2007 US 957221
(43) Date of publication of application: 18.08.2010
(73) Proprietor: Performance Materials NA, Inc., Midland, Michigan 48674 (US)
(72) Inventor: HAYES, Richard, Allen, Beaumont Texas 77706 (US); SAMUELS, Sam, Louis, Landenberg Pennsylvania 19350 (US)
(74) Representative: Boult Wade Tennant LLP
(86) International application number: PCT/US2008/086364
(87) International publication number: WO 2009/079322

(56) References cited:
- EP-A2- 1 065 731
- WO-A2-2007/027861
- WO-A2-2009/064863
- US-A1- 2005 279 401
- US-A1- 2006 165 929
- US-A1- 2007 154 694

## Description

The present invention relates to a terionomer containing film or sheet and articles comprising the same.

### BACKGROUND OF THE INVENTION

Glass laminated products, such as safety glass, have contributed to society for almost a century. Safety glass also found uses in structural, decorative or other architectural applications.

Safety glass typically consists of a sandwich of two glass sheets or panels bonded together with a polymeric interlayer of a polymeric sheet. One or both of the glass sheets may be replaced with optically clear rigid polymeric sheets, such as sheets of polycarbonate materials. Safety glass has further evolved to include multiple layers of glass and/or rigid polymeric sheets bonded together with interlayers.

The interlayer is typically made with a relatively thick polymer sheet, which exhibits toughness and bondability to provide adhesion to the glass in the event of a crack or crash. Widely used interlayer materials include complex, multicomponent compositions based on poly(vinyl butyral) (PVB), poly(urethane) (PU), poly(ethylene-co-vinyl acetate) (EVA), and the like.

As a sustainable energy resource, the use of solar cell modules is rapidly expanding. One preferred way of manufacturing a solar cell module involves forming a pre-lamination assembly comprising at least 5 structural layers. The solar cell pre-lamination assemblies are constructed in the following order starting from the top, or incident layer (that is, the layer first contacted by light) and continuing to the backing layer (the layer furthest removed from the incident layer): (1) incident layer (typically a glass plate or a thin polymeric film (such as a fluoropolymer or polyester film), but could conceivably be any material that is transparent to sunlight), (2) front encapsulant layer, (3) solar cell component, (4) back encapsulant layer, and (5) backing layer.

The encapsulant layers are designed to encapsulate and protect the fragile solar cell component. Generally, a solar cell pre-lamination assembly incorporates at least two encapsulant layers sandwiched around the solar cell component. The optical properties of the front encapsulant layer may be such that light can be effectively transmitted to the solar cell component. Additionally, encapsulant layers generally have similar requirements and compositions to that described above for safety glass interlayers.

The use of ionomers, which are derived from partially or fully neutralized acid copolymers of α-olefins and α,β-ethylenically unsaturated carboxylic acids, in safety glass interlayers have been disclosed in U.S. Pat Nos. 3,344,014; 3,762,988; 4,663,228; 4,668,574; 4,799,346; 5,759,698; 5,763,062; 5,895,721; 6,150,028; and 6,432,522, U.S. Pat Pub Nos. 2002/0155302 and US 2002/0155302, and PCT Pat Pub Nos. WO 99/58334 and WO 2006/057771. Such ionomers have also been used in solar cell encapsulant layers, see e.g., U.S. Pat Nos. 5,476,553; 5,478,402; 5,733,382; 5,762,720; 5,986,203; 6,114,046; 6,187,448; and 6,660,930, U.S. Pat Pub Nos. 2003/0000568; 2005/0279401; 2006/0084763; and 2006/0165929, and Japanese Pat Nos. JP 2000186114 and JP 2006032308.
EP 1 065 731 A2 describes a solar cell module comprising a photovoltaic element, the light-receiving surface and/or non-light-receiving surface of the photovoltaic element being sealed by organic polymeric resin layers, wherein at least one of the organic polymeric resin layers contains a specific ethylene-unsaturated fatty acid ester-unsaturated fatty acid terpolymer.
US 2006/165929 A1 discloses an optically transparent laminate film comprising: at least three layers of film, wherein at least two of the at least three layers comprise ionomeric films, and wherein the film can be suitable for use in a photovoltaic cell or in packaging.
WO 2009/064863 A2 falling under Art. 54(3) EPC describes a cell pre-lamination assembly comprising a terionomer multilayer film or sheet and a solar cell module which is prepared from the assembly.

Terionomers, which are derived from partially or fully neutralized acid terpolymers of α-olefins, α,β-ethylenically unsaturated carboxylic acids, and α,β-ethylenically unsaturated carboxylic acid esters, have also been used in forming safety glass interlayers (see e.g., U.S. Pat Nos. 3,344,014 and 5,759,698) or solar cell encapsulant layers (see e.g., U.S. Pat Pub No. 2006/0165929 and Japanese Pat No. JP 2006032308).

However, safety glass interlayers and solar cell encapsulant layers formed of such ionomers are lack of adequate light transmission properties and sufficient adhesion strength to other laminate layers, especially under severe environmental conditions. Moreover, the solar cell encapsulant layers formed of such ionomers often fail to provide adequate protection to the solar cell component from shock. On the other hand, safety glass interlayers and solar encapsulant layers formed of the terionomers taught by the prior art also do not have the desired light transmission property and adhesion strength to other laminate layers.

There is a need for polymeric films or sheets suitable as safety glass interlayers or solar cell encapsulant layers, which are transparent and highly adhesive to other laminate layers.

### SUMMARY OF THE INVENTION

The invention is directed to a solar cell pre-lamination assembly comprising (i) a solar cell component comprises or is formed of one or a plurality of electronically interconnected solar cells and having a light-receiving side that faces a light source and a back side that is opposite from the light source and (ii) a film or sheet made of a terionomer composition, wherein the terionomer is derived from an acid terpolymer that comprises copolymerized units derived from an α-olefin, 18 to 25 wt% of an α,β-ethylenically unsaturated carboxylic acid having 3 to 8 carbons, and 0.5 to 40 wt% of an α,β-ethylenically unsaturated carboxylic acid ester having 4 to 12 carbons, based on the total weight of the acid terpolymer, and has 5% to 90% of its carboxylic acid content neutralized with one or more metal ions,
wherein the film or sheet is a single layer.

The invention is further directed to a process comprising:
(i) providing a solar cell pre-lamination assembly as described above and
(ii) laminating the assembly to form a solar cell module.

The invention is further directed to a solar cell module produced from the solar cell pre-lamination assembly as described above.

### DETAILED DESCRIPTION OF THE INVENTION

The term "acid copolymer" refers to a polymer comprising copolymerized units derived from an α-olefin, an α,β-ethylenically unsaturated carboxylic acid, and optionally other suitable comonomers such as, for example, an α,β-ethylenically unsaturated carboxylic acid ester.

The term "acid terpolymer" refers to a species of acid copolymers, which comprise copolymerized units derived from an α-olefin, an α,β-ethylenically unsaturated carboxylic acid, and an α,β-ethylenically unsaturated carboxylic acid ester.

The term "ionomer" refers to a polymer that is derived from a parent acid copolymer, as disclosed above, by partially or fully neutralizing the parent acid copolymer.

The term "terionomer" refers to a species of ionomers, which are derived from a parent acid terpolymer, as disclosed above.

### Terionomer Films and Sheets

The invention provides a film or sheet made of a terionomer composition and an article comprising the same, wherein the terionomer is derived from a parent acid terpolymer that contains copolymerized units derived from an α-olefin having 2 to 10 carbons, 18 to 25 wt% of an α,β-ethylenically unsaturated carboxylic acid having 3 to 8 carbons, and 0.5 to 40 wt% of an α,β-ethylenically unsaturated carboxylic acid ester having 4 to 12 carbons, based on the total weight of the acid terpolymer, and is 5% to 90% neutralized with one or more metal ions, based on the total carboxylic acid content of the acid terpolymer, wherein the film or sheet is a single layer.

Preferably, the parent acid terpolymer comprises 18 to 23 wt%, of copolymerized units of the α,β-ethylenically unsaturated carboxylic acid. Preferably, the parent acid terpolymer comprises 0.5 to 5 wt%, or 15 to 40 wt%, or 15 to 25 wt% or copolymerized units of the α,β-ethylenically unsaturated carboxylic acid ester.

The α-olefin comonomers may include, but are not limited to, ethylene, propylene, 1-butene, 1-pentene, 1-hexene, 1-heptene, 3 methyl-1-butene, 4-methyl-1-pentene, and the like and mixtures of two or more thereof. Preferably, the α-olefin is ethylene.

The α,β-ethylenically unsaturated carboxylic acid comonomers may include, but are not limited to, acrylic acids, methacrylic acids, itaconic acids, maleic acids, maleic anhydrides, fumaric acids, monomethyl maleic acids, and mixtures of two or more thereof. Preferably, the α,β-ethylenically unsaturated carboxylic acid is selected from acrylic acids, methacrylic acids, and mixtures of two or more thereof.

The α,β-ethylenically unsaturated carboxylic acid ester comonomers may include, but are not limited to, methyl acrylates, methyl methacrylates, ethyl acrylates, ethyl methacrylates, isopropyl acrylates, isopropyl methacrylates, butyl acrylates, butyl methacrylates, and mixtures of two or more thereof. Preferably, the α,β-ethylenically unsaturated carboxylic acid ester is selected from methyl acrylates and butyl acrylates.

The parent acid terpolymers may be polymerized as disclosed in U.S. Pat Nos. 3,404,134; 5,028,674; 6,500,888; and 6,518,365.

To obtain the terionomers, the parent acid terpolymers are preferably 10% to 50%, or 20% to 40%, neutralized with metallic ion(s), based on the total carboxylic acid content of the parent acid terpolymers. The metallic ions may be monovalent, divalent, trivalent, multivalent, or mixtures thereof. Useful monovalent metallic ions include, but are not limited to, sodium, potassium, lithium, silver, mercury, copper, and mixtures of two or more thereof. Useful divalent metallic ions include, but are not limited to, beryllium, magnesium, calcium, strontium, barium, copper, cadmium, mercury, tin, lead, iron, cobalt, nickel, zinc, and mixtures of two or more thereof. Useful trivalent metallic ions include, but are not limited to, aluminum, scandium, iron, yttrium, and mixtures of two or more thereof. Useful multivalent metallic ions include, but are not limited to, titanium, zirconium, hafnium, vanadium, tantalum, tungsten, chromium, cerium, iron, and mixtures of two or more thereof. It is noted that when a multivalent metallic ion is used, complexing agents, such as stearate, oleate, salicylate, and phenolate radicals are included, as disclosed within U.S. Pat No. 3,404,134. Preferably, the metallic ions are selected from sodium, lithium, magnesium, zinc, and mixtures of two of more thereof. More preferably, the metallic ions are selected from sodium, zinc, and mixtures thereof. Most preferably, the metallic ion is zinc. The parent acid terpolymers may be neutralized as disclosed in U.S. Pat No. 3,404,134.

A preferred example of the terionomers is derived from a poly(ethylene-co-butyl acrylate-co-methacrylic acid), wherein 20% to 40% of the methacrylic acids are neutralized with zinc.

The terionomer compositions may further comprise any suitable additives known within the art including plasticizers, processing aides, lubricants, flame retardants, impact modifiers, nucleating agents, antiblocking agents (e.g., silica), thermal stabilizers, UV absorbers, UV stabilizers, dispersants, surfactants, chelating agents, coupling agents, adhesives, primers, the like, or mixtures of two or more thereof. The total amount of additives comprised in a terionomer composition may be from 0.001 up to 5 wt%, based on the total weight of the composition.

The terionomer composition optionally further comprises one or more silane coupling agents to further enhance the adhesion strength of the film or sheet comprising the same. Exemplary coupling agents include, but are not limited to, γ-chloropropylmethoxysilane, vinyltrimethoxysilane, vinyltriethoxysilane, vinyltris(β-methoxyethoxy)silane,γ-vinylbenzylpropyltrimethoxysilane, N-β-(N-vinylbenzylaminoethyl)-γ-aminopropyltrimethoxysilane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropylmethoxysilane, γ-aminopropyltriethoxysilane, N-β-(aminoethyl)-γ-aminopropyltrimethoxysilane, and the like and mixtures of two or more thereof. The silane coupling agents are preferably present in the terionomer composition at a level of 0.01 to 5 wt%, or 0.05 to 1 wt%, based on the total weight of the composition. The adhesion promoting agents may also be absent from the terionomer compositions, especially when they are comprised in the surface sub-layers of the films or sheets.

The terionomer compositions optionally further comprises additives to reduce the melt flow of the resin, to the limit of thermosetting the films or sheets derived therefrom during lamination and therefore provide lamination products comprising the same with even greater thermal resistance and fire resistance. By the addition of such additives, the end-use temperature may be enhanced by 20°C to 70°C. Typically, the effective melt flow reducing additives are organic peroxides, such as 2,5-dimethylhexane-2,5-dihydroperoxide, 2,5-dimethyl-2,5-di(tert-betylperoxy)hexane-3, di-tert-butyl peroxide, tert-butylcumyl peroxide, 2,5-dimethyl-2,5-di(tert-butylperoxy)hexane, dicumyl peroxide, a,a'-bis(tert-butyl-peroxyisopropyl)benzene, n-butyl-4,4-bis(tert-butylperoxy)valerate, 2,2-bis(tert-butylperoxy)butane, 1,1-bis(tert-butyl-peroxy)cyclohexane, 1,1-bis(tert-butylperoxy)-3,3,5-trimethyl-cyclohexane, tert-butyl peroxybenzoate, benzoyl peroxide, and the like and mixtures or combinations thereof. The organic peroxides may decompose at a temperature of 100°C or higher to generate radicals or have a decomposition temperature which affords a half life of 10 hours at 70°C or higher to provide improved stability for blending operations. The organic peroxides may be added at a level of 0.01 to 10 wt%, or 0.5 to 3.0 wt%, based on the total weight of the composition. The flow reducing additives may also be absent from the terionomer composition to provide sufficient polymeric flow during lamination and sufficient adhesion to other laminate layers.

If desired, initiators, such as dibutyltin dilaurate, may be contained in the terionomer compositions at a level of 0.01 to 0.05 wt%, based on the total weight of the composition. In addition, if desired, inhibitors, such as hydroquinone, hydroquinone monomethyl ether, p-benzoquinone, and methylhydroquinone, may be added to the acid terpolymer compositions at a level of less than 5 wt%, based on the total weight of the composition.

The terionomer containing film or sheet is in a single-layer form. A multilayer form is also described herein. By "single-layer", it is meant that the film or sheet has only one single layer that is made of the terionomer composition. A terionomer film or sheet which is a multilayer film or sheet having two surface sub-layers and optionally one or more inner sub-layers with at least one of the sub-layers comprising or made of the terionomer composition is also described herein. The term "surface sub-layers" refers to the two sub-layers forming the two outer surfaces of the multilayer film or sheet and the term "inner sub-layer(s)" refers to the sub-layer(s) sandwiched between the two surface sub-layers. More preferably, the terionomer film or sheet is a multilayer film or sheet having at least one of the two surface sub-layers comprising or made of the terionomer composition.

When the terionomer containing film or sheet is in a multilayer form, the other non-terionomer-containing sub-layer(s) may be formed of any other suitable polymer compositions comprising polymeric materials selected from acid copolymers, ionomers, poly(ethylene-co-vinyl acetates), poly(vinyl acetals) (e.g., poly(vinyl butyrals)), thermoplastic polyurethanes, poly(vinyl chlorides), polyethylenes (e.g., metallocene-catalyzed linear low density polyethylenes), polyolefin block elastomers, poly(α-olefin-co-α,β-ethylenically unsaturated carboxylic acid ester) copolymers (e.g., poly(ethylene-co-methyl acrylate) and poly(ethylene-co-butyl acrylate)), silicone elastomers, epoxy resins, and mixtures of two or more thereof. Preferably, the other sub-layer(s) comprise or are made of ionomers derived from acid copolymers that comprise copolymerized units of α-olefins, α,β-ethylenically unsaturated carboxylic acids, and optionally α,β-ethylenically unsaturated carboxylic acid esters, and are neutralized to a level of 1% to 90%, or 10% to 40% with metal ion(s), such as zinc, magnesium, lithium, and mixtures of two or more thereof. The preferred metal ion is zinc. More preferably, the other sub-layer(s) are made of ionomers having a melting point of at least 80°C, or at least 90°C, or at least 95°C to provide excellent creep resistance when the film or sheet is used in lamination articles. Specific examples of such ionomeric compositions include those Surlyn® products available from E. I. du Pont de Nemours and Company, Wilmington, DE (DuPont). Most preferably, the terionomer containing film or sheet is a multilayer film or sheet with two surface sub-layers each comprising or made of the terionomer composition disclosed here and at least one inner sub-layer comprising or made of the above mentioned ionomer with high melting point.

The terionomer containing film or sheet may have a total thickness of 2 mils (0.051 mm) to 250 mils (6.35 mm). When in a multilayer form, each of the terionomer containing sub-layer(s) may have a thickness of 0.5 mils (0.013 mm) to 5 mils (0.13 mm), or 0.5 mils to 3 mils (0.076 mm), and each of the other sub-layer(s) may have a thickness of 0.5 mils (0.013 mm) to 120 mils (3 mm), or 10 mils (0.25 mm) to 90 mils (2.28 mm), or 30 mils (0.76 mm) to 60 mils (1.52 mm).

When the terionomer film or sheet is comprised in a safety laminate as an interlayer film or sheet, it is preferred to have a total thickness of 10 mils (0.25 mm) to 250 mils (6.35 mm), or 15 mils (0.38 mm) to 90 mils (2.28 mm), or 30 mils (0.76 mm) to 60 mils (1.52 mm), and when the film or sheet is comprised in a solar cell module as an encapsulant layer, it is preferred to have a total thickness of 2 mils (0.051 mm) to 20 mils (0.51 mm). In addition, with flexible solar cell laminates, it is preferred to have at least one encapsulant layer formed of a thin terionomer film as disclosed above, which has a thickness of 2 mils (0.051 mm) to 10 mils (0.25 mm), or 2 mils (0.051 mm) to 5 mils (0.13 mm), and with rigid solar cell laminates, it is preferred to have at least one encapsulant layer formed of a thick terionomer sheet as disclosed above, which has a thickness of 10 mils (0.25 mm) to 20 mils (0.51 mm).

The terionomer films or sheets may have smooth or rough surfaces on one or both sides. Preferably, the films or sheets have rough surfaces on both sides to facilitate the deareation of the laminates during the laminate process. Rough surfaces can be made by mechanically embossing or by melt fracture during extrusion of the films or sheets followed by quenching so that the roughness is retained during handling. The surface pattern can be applied to the terionomer film or sheet through common art processes. For example, the as-extruded film or sheet may be passed over a specially prepared surface of a die roll positioned in close proximity to the exit of the die which imparts the desired surface characteristics to one side of the molten polymer. Thus, when the surface of such roll has minute peaks and valleys, the polymer film or sheet cast thereon will have a rough surface on the side which contacts the roll which generally conforms respectively to the valleys and peaks of the roll surface. Such die rolls are disclosed in, e.g., U.S. Pat No. 4,035,549, U.S. Pat Pub No. 2003/0124296, and U.S. Pat Pub No. 2008/0286530.

The terionomer films or sheets can be produced by any suitable process. For example, the films or sheets may be formed through dipcoating, solution casting, compression molding, injection molding, lamination, melt extrusion, blown film, extrusion coating, tandem extrusion coating, or any other procedures that are known to those of skill in the art. Preferably, the films or sheets are formed by melt coextrusion, melt extrusion coating, or tandem melt extrusion coating processes.

The terionomer film or sheet has a percent transmission of 80% to 100%, as measured by ASTM D1003. Preferably, the terionomer film or sheet has a percent transmission of 90% to 100% transmission. In addition, it desirably provides a percent clarity of 90% to 100%, or 95% to 100%, or 98% to 100%, as measured by ASTM D1003.

### Articles

The invention further provides a pre-lamination or lamination article (e.g., a safety laminate, a solar cell pre-lamination assembly, or a solar cell module derived therefrom) comprising at least one layer of the terionomer containing film or sheet disclosed herein.

The use of such a terionomer film or sheet in safety laminates and solar cell modules provides advantages over other prior art polymeric films or sheet. First, the terionomer film or sheet has enhanced adhesion strength to other laminate layers, especially after severe environmental aging. For example, the enhanced adhesion strength can be shown after the laminate has undergone a damp heat test at 85°C and 85% relative humidity for 1000 hours, or a thermal cycling test in accordance to the International Electrotechnical Commission (IEC) test method 16215, sections 10-11 and/or 10-12. Specifically, the adhesion strength between the acid terpolymer containing film or sheet and its adjacent laminate layer(s) may be measured by a 180° peel strength test using an Instron® Model # 1125 (1000 lb (454 kg) test frame) Tester in accordance to ASTM D903 as modified with a cross-head speed of 100 mm/min. Secondly, in those embodiments where the terionomers are derived from parent acid terpolymers comprising 0.5 to 5 wt% of copolymerized units of the α,β-ethylenically unsaturated carboxylic acid esters, the terionomer containing films or sheets further exhibit improved shock resistance, and in those embodiments where the terionomers are derived from parent acid terpolymers comprising 15 to 40 wt%, or 15 to 25 wt% of copolymerized units of the α,β-ethylenically unsaturated carboxylic acid esters, the terionomer containing films or sheets further exhibit improved transparency.

In one embodiment, the lamination article is a safety laminate including a polymeric interlayer comprising a layer of the above disclosed terionomer film or sheet.

The polymeric interlayer optionally further comprises one or more other interlayer films or sheets made of other suitable polymeric materials. Such optional other interlayer sheets may be made of polymeric materials selected from acid copolymers, ionomers, poly(ethylene-co-vinyl acetates), poly(vinyl acetals) (including acoustic grade poly(vinyl acetals)), polyurethane, poly(vinyl chlorides), polyethylenes (e.g., metallocene-catalyzed low density polyethylenes), polyolefin block elastomers, ethylene acrylate ester copolymers (e.g., poly(ethylene-co-methyl acrylate) and poly(ethylene-co-butyl acrylate)), silicone elastomers, epoxy resins, and mixtures of two or more thereof. Such optional other interlayer films may be made of a polymeric materials selected from polyesters (e.g., poly(ethylene terephthalate) and poly(ethylene naphthalates)), polycarbonates, polyolefins (e.g., polypropylene, polyethylene, and cyclic polyolefins), norbornene polymers, polystyrenes (including syndiotactic polystyrenes), styrene-acrylate copolymers, acrylonitrile-styrene copolymers, polysulfones (e.g., polyethersulfone, polysulfone, etc.), nylons, poly(urethanes), acrylics, cellulose acetates (e.g., cellulose acetate, cellulose triacetates, etc.), cellophanes, vinyl chloride polymers (e.g., poly(vinylidene chloride)), fluoropolymers (e.g., polyvinyl fluoride, polyvinylidene fluoride, polytetrafluoroethylene, ethylene-tetrafluoroethylene copolymers, etc.) and mixtures of two or more thereof. The optionally other interlayer films may also be coated if desired. For example, the films may be coated with organic infrared absorbers and sputtered metal layers, such as silver, coatings and the like. Metal coated polymeric films are disclosed in, e.g., U.S. Pat Nos. 3,718,535; 3,816,201; 4,465,736; 4,450,201; 4,799,745; 4,846,949; 4,954,383; 4,973,511; 5,071,206; 5,306,547; 6,049,419; 6,104,530; 6,204,480; 6,255,031; and 6,565,982. For example, the coating may function as oxygen and moisture barrier coatings, such as the metal oxide coating disclosed within U.S. Patent Nos. 6,521,825 and 6,818,819 and European Pat No. EP1182710.

The thickness of the other optional interlayer film(s) may range from 0.1 mil (0.003 mm) to 10 mils (0.26 mm), or preferably, from 1 mil (0.025 mm) to 7 mils (0.18 mm), the thickness of the other optional interlayer sheet(s) may be 10 mils (0.25 mm) to 250 mils (6.35 mm), or 15 mils (0.38 mm) to 90 mils (2.28 mm), or 30 mils (0.76 mm) to 60 mils (1.52 mm), and the total thickness of all the component films or sheets in the interlayer does not exceed 250 mils (6.35 mm).

The laminate may further comprise an outer layer bonded to one side of the interlayer, or two outer layers bonded to each side of the interlayer where each outer layer may be a rigid sheet or a polymeric film.

The rigid sheets include glass sheets and rigid polymeric sheets having a thickness of 10 mils (0.25 mm) to 250 mils (6.35 mm) including, but not limited to, polycarbonates, acrylics, polyacrylates, cyclic polyolefins (e.g., ethylene norbornene polymers), polystyrenes (preferably metallocene-catalyzed polystyrenes), polyamides, polyesters, fluoropolymers and the like and combinations of two or more thereof. Preferably, the rigid polymeric sheets are made of polymeric materials having a modulus of at least 10,000 psi (69 MPa)

Glass includes not only window glass, plate glass, silicate glass, sheet glass, low iron glass, tempered glass, tempered CeO-free glass, and float glass, but also to include colored glass, specialty glass (such as those include ingredients to control, e.g., solar heating), coated glass (such as those sputtered with metals (e.g., silver or indium tin oxide) for solar control purposes), E-glass, Toroglass, Solex® glass (PPG Industries, Pittsburgh, PA). Such specialty glasses are disclosed in, e.g., U.S. Pat Nos. 4,615,989; 5,173,212; 5,264,286; 6,150,028; 6,340,646; 6,461,736; and 6,468,934. The type of glass to be selected for a particular laminate depends on the intended use.

The polymeric films are preferably made of materials selected from polyesters (e.g., poly(ethylene terephthalate) and poly(ethylene naphthalates)), polycarbonates, polyolefins (e.g., polypropylenes, polyethylenes, and cyclic polyloefins), norbornene polymers, polystyrenes (e.g., syndiotactic polystyrenes), styrene-acrylate copolymers, acrylonitrile-styrene copolymers, polysulfones (e.g., polyethersulfones, polysulfones, etc.), nylons, poly(urethanes), acrylics, cellulose acetates (e.g., cellulose acetates, cellulose triacetates, etc.), cellophanes, poly(vinyl chlorides) (e.g., poly(vinylidene chlorides)), fluoropolymers (e.g., polyvinyl fluorides, polyvinylidene fluorides, polytetrafluoroethylenes, ethylene-tetrafluoroethylene copolymers, etc.), and the like or combinations of two or more thereof. More preferably, the polymeric films are polyester films, or most preferably, bi-axially oriented poly(ethylene terephthalate) films. Preferably, the polymeric films are hardcoated on the outside surface. By "hardcoated", it is meant that a clear anti-scratch and anti-abrasion hardcoat is coated on the outside surface of the polymeric film, with the outside surface being the surface that is further away from the interlayer of the safety laminate. Hardcoat may comprise or be produced from polysiloxanes or cross-linked (thermosetting) polyurethanes. Also applicable herein are the oligomeric-based coatings disclosed in U.S. Pat Pub No. 2005/0077002, which compositions are prepared by the reaction of (A) hydroxyl-containing oligomer with isocyanate-containing oligomer or (B) anhydride-containing oligomer with epoxide-containing compound. Preferably, the hardcoat is formed of polysiloxane abrasion resistant coatings (PARC), such as those disclosed in U.S. Pat Nos. 4,177,315; 4,469,743; 5,415,942; and 5,763,089.

Prior to applying the hardcoat, the outside surface of the polymeric film may need to undergo adhesion enhancing treatment as disclosed below.

The polymeric films may also have a solar control material coated on one or both of its surfaces. Solar control materials may be infrared absorbing materials, such as metal oxide nanoparticles (e.g., antimony tin oxide nanoparticles, indium tin oxide nanoparticles, or combinations thereof), metal boride nanoparticles (e.g., lanthanum hexaboride nanoparticles), or combinations of two or more thereof. The polymeric films may also be coated with an infrared energy reflective layer, such as a metal layer, a Fabry-Perot type interference filter layer, a layer of liquid crystals, or combinations of two or more thereof.

If desired, one or both surfaces of the laminate layers, such as the terionomer film(s) or sheet(s) disclosed herein, the optional other interlayer sheet(s) or film layer(s), the rigid sheet(s), or the polymeric film(s), may be treated to further enhance the adhesion to other laminate layers. This adhesion enhancing treatment may take any form known within the art and include flame treatments (see, e.g., U.S. Pat Nos. 2,632,921; 2,648,097; 2,683,894; and 2,704,382), plasma treatments (see e.g., U.S. Pat No. 4,732,814), electron beam treatments, oxidation treatments, corona discharge treatments, chemical treatments, chromic acid treatments, hot air treatments, ozone treatments, ultraviolet light treatments, sand blast treatments, solvent treatments, and the like and combinations of two or more thereof. Also, the adhesion strength may be further improved by further applying an adhesive or primer coating on the surface of laminate layer(s). For example, U.S. Pat. No. 4,865,711 discloses a film or sheet with improved bondability, which has a thin layer of carbon deposited on one or both surfaces. Other exemplary adhesives or primers may include silanes, poly(allyl amine) based primers (see e.g., U.S. Pat Nos. 5,411,845; 5,770,312; 5,690,994; and 5,698,329), and acrylic based primers (see e.g., U.S. Pat No. 5,415,942). The adhesive or primer coating may take the form of a monolayer of the adhesive or primer and have a thickness of 0.0004 to 1 mil (0.00001 to 0.03 mm), or preferably, 0.004 to 0.5 mil (0.0001 to 0.013 mm), or more preferably, 0.004 to 0.1 mil (0.0001 to 0.003 mm).

The adhesives or primers coating may be 0.0004 mil (0.00001 mm) to 1 mil (0.03 mm), or 0.004 mil (0.0001 mm) to 0.5 mil (0.013 mm), or 0.004 mil (0.0001 mm) to 0.1 mil (0.003 mm) thick.

The terionomer films and sheets may also not undergo any adhesion enhancing treatment and are self-adhered to the other laminate layers.

The safety laminate may take any form known within the art. Preferable specific glass laminate constructions include:
- glass/TI;
- glass/TI/film;
- glass/TI/glass;
- film/TI/film;
- glass/TI/film/TI/glass;
- glass/TI/film/TI/film;
and the like, wherein "TI" stands for the terionomer film or sheet disclosed above.

The safety laminates may be produced by any of the lamination process that are described below in detail, or by other processes known to one skilled in the art.

The laminate may be a solar cell pre-lamination assembly which comprises a solar cell component formed of one or a plurality solar cells and at least one layer of the acid terpolymer film or sheet described above.

Solar cell is meant to include any article which can convert light into electrical energy. Typical art examples of the various forms of solar cells include, for example, single crystal silicon solar cells, polycrystal silicon solar cells, microcrystal silicon solar cells, amorphous silicon based solar cells, copper indium selenide solar cells, compound semiconductor solar cells, dye sensitized solar cells, and the like. The most common types of solar cells include multi-crystalline solar cells, thin film solar cells, compound semiconductor solar cells and amorphous silicon solar cells.

Thin film solar cells are typically produced by depositing several thin film layers onto a substrate, such as glass or a flexible film, with the layers being patterned so as to form a plurality of individual cells which are electrically interconnected to produce a suitable voltage output. Depending on the sequence in which the multi-layer deposition is carried out, the substrate may serve as the rear surface or as a front window for the solar cell module. By way of example, thin film solar cells are disclosed in U.S. Pat Nos. 5,512,107; 5,948,176; 5,994,163; 6,040,521; 6,137,048; and 6,258,620.

The solar cell pre-lamination assembly typically comprises at least one layer of the terionomer film or sheet, which is positioned next to the solar cell component and serves as one of the encapsulant layers, or preferably, the terionomer film or sheet is positioned next to the solar cell component to the light-receiving side and serves as the front encapsulant layer.

The solar cell pre-lamination assembly may further comprise encapsulant layers formed of other polymeric materials, such as, acid copolymers, ionomers, ethylene vinyl acetates, poly(vinyl acetals) (including acoustic grade poly(vinyl acetals), polyurethanes, polyvinylchlorides, polyethylenes (e.g., linear low density polyethylenes), polyolefin block elastomers, poly(α-olefin-co-α,β-ethylenically unsaturated carboxylic acid ester) copolymers (e.g., poly(ethylene-co-methyl acrylate) and poly(ethylene-co-butyl acrylate)), silicone elastomers, epoxy resins, and combinations of two or more thereof. Preferably, the solar cell pre-lamination assembly comprises two layers of the terionomer film or sheet, wherein each of the two acid terpolymer films or sheets are laminated to each of the two sides of the solar cell component and serve as the front and back encapsulant layers.

The thickness of the individual encapsulant layers other than the terionomer film(s) or sheet(s) may independently range from 1 mil (0.026 mm) to 120 mils (3 mm), or from 1 mil to 40 mils (1.02 mm), or from 1 mil to 20 mils (0.51 mm). All the encapsulant layer(s) comprised in the solar cell pre-lamination assemblies, may have smooth or rough surfaces. Preferably, the encapsulant layer(s) have rough surfaces to facilitate the deareation of the laminates through the lamination process.

The solar cell pre-lamination assembly may yet further comprise an incident layer and/or a backing layer serving as the outer layers of the assembly at the light-receiving side and the back side, respectively.

The outer layers of the solar cell pre-lamination assemblies, i.e., the incident layer and the backing layer, may be derived from any suitable sheets or films. Suitable sheets may be glass or plastic sheets, such as, polycarbonates, acrylics, polyacrylates, cyclic polyolefins (e.g., ethylene norbornene polymers), polystyrenes (preferably metallocene-catalyzed polystyrenes), polyamides, polyesters, fluoropolymers and the like and combinations of two or more thereof. In addition, metal sheets, such as aluminum, steel, galvanized steel, or ceramic plates may be utilized in forming the backing layer. Suitable films may be made of polymers selected from polyesters (e.g., poly(ethylene terephthalates) and poly(ethylene naphthalates)), polycarbonates, polyolefins (e.g., polypropylenes, polyethylenes, and cyclic polyloefins), norbornene polymers, polystyrenes (e.g., syndiotactic polystyrenes), styrene-acrylate copolymers, acrylonitrile-styrene copolymers, polysulfones (e.g., polyethersulfones, polysulfones, etc.), nylons, poly(urethanes), acrylics, cellulose acetates (e.g., cellulose acetate, cellulose triacetates, etc.), cellophanes, poly(vinyl chlorides) (e.g., poly(vinylidene chlorides)), fluoropolymers (e.g., polyvinyl fluorides, polyvinylidene fluorides, polytetrafluoroethylenes, ethylene-tetrafluoroethylene copolymers, etc.) and the like, or combinations of two or more thereof. The polymeric film may be bi-axially oriented polyester film (preferably poly(ethylene terephthalate) film) or a fluoropolymer film (e.g., Tedlar®, Tefzel®, and Teflon® films, from DuPont). Fluoropolymer-polyester-fluoropolymer ("TPT") films are also preferred for some applications. Metal films, such as aluminum foil may also be used as the back-sheet.

The solar cell pre-lamination assembly may further comprise other functional film or sheet layers (e.g., dielectric layers or barrier layers) embedded within the assembly. Such functional layers may be derived from any of the above mentioned polymeric films or those that are coated with additional functional coatings. For example, poly(ethylene terephthalate) films coated with a metal oxide coating, such as those disclosed within U.S. Pat Nos. 6,521,825; 6,818,819; and European Pat No. EP1182710, may function as oxygen and moisture barrier layers in the laminates.

If desired, a layer of non-woven glass fiber (scrim) may also be included in the solar cell laminates to facilitate deareation during the lamination process or to serve as reinforcement for the encapsulant layer(s). The use of such scrim layers within solar cell laminates is disclosed within, e.g., U.S. Pat Nos. 5,583,057; 6,075,202; 6,204,443; 6,320,115; 6,323416; and European Pat No. EP0769818.

The film or sheet layers positioned to the light-receiving side of the solar cell component may be made of transparent material to allow efficient transmission of sunlight into the solar cell component. A special film or sheet may be included to serve both the function of an encapsulant layer and an outer layer. It is also conceivable that any of the film or sheet layers included in the assembly may be in the form of a pre-formed single-layer or multilayer film or sheet.

If desired, one or both surfaces of the laminate layer(s) of the solar cell pre-lamination assembly, such as the terionomer containing film(s) or sheet(s), may be treated to enhance the adhesion strength, as described above.

The terionomer films and sheets may also not undergo any adhesion enhancing treatment and are self-adhered to the other laminate layers.

The solar cell pre-lamination assemblies may take any form known within the art. Preferable specific solar cell pre-lamination constructions (top (light receiving) side to back side) include,
- glass/TI/solar cell/TI/glass;
- glass/TI/solar cell/TI/fluoropolymer film (e.g., Tedlar® film);
- fluoropolymer film/TI/solar cell/TI/glass;
- fluoropolymer film/TI/solar cell/TI/fluoropolymer film;
- glass/TI/solar cell/TI/polyester film (e.g., poly(ethylene terephthalate) film);
- fluoropolymer film/TI/solar cell/TI/polyester film;
- glass/TI/solar cell/TI/barrier coated film/TI/glass;
- fluoropolymer film/TI/barrier coated film/TI/solar cell/TI/barrier coated film/TI/fluoropolymer film;
- glass/TI/solar cell/TI/aluminum stock;
- fluoropolymer film/TI/solar cell/TI/aluminum stock;
- glass/TI/solar cell/TI/galvanized steel sheet;
- glass/TI/solar cell/TI/polyester film/TI/aluminum stock;
- fluoropolymer film/TI/solar cell/TI/polyester film/TI/aluminum stock;
- glass/TI/solar cell/TI/polyester film/TI/galvanized steel sheet;
- fluoropolymer film/TI/solar cell/TI/polyester film/TI/galvanized steel sheet;
- glass/TI/solar cell/poly(vinyl butyral) encapsulant layer/glass;
- glass/TI/solar cell/poly(vinyl butyral) encapsulant layer/fluoropolymer film;
- fluoropolymer film/TI/solar cell/acid copolymer encapsulant layer/fluoropolymer film;
- glass/TI/solar cell/ethylene vinyl acetate encapsulant layer/polyester film;
- fluoropolymer film/TI/solar cell/poly(ethylene-co-methyl acrylate) encapsulant layer/polyester film;
- glass/poly(ethylene-co-butyl acrylate) encapsulant layer/solar cell/TI/barrier coated film/poly(ethylene-co-butyl acrylate) encapsulant layer/glass;
and the like, wherein "TI" stands for the terionomer film or sheet. In addition, besides the Tedlar® film from DuPont, suitable fluoropolymer films also include TPT trilayer films.

The invention further provides solar cell laminates derived from the solar cell pre-lamination assemblies disclosed above. Specifically the solar cell laminates are formed by subjecting the solar cell pre-lamination assemblies to further lamination process, as provided below in detail.

### Lamination Process

Any lamination process known within the art may be used to prepare the safety glass laminates or solar cell laminates. The lamination process may be an autoclave or non-autoclave process.

In an exemplary process, the component layers of a safety glass laminate or a solar cell pre-lamination assembly are stacked up in the desired order to form a pre-lamination assembly. The assembly is then placed into a bag capable of sustaining a vacuum ("a vacuum bag"), the air is drawn out of the bag by a vacuum line or other means, the bag is sealed while the vacuum is maintained (e.g., 27 to 28 in Hg (689 to 711 mm Hg)), and the sealed bag is placed in an autoclave at a pressure of 150 to 250 psi (11.3 to 18.8 bar), a temperature of 130°C to 180°C, or 120°C to 160°C, or 135°C to 160°C, or 145°C to 155°C, for 10 to 50 minutes, or 20 to 45 minutes, or 20 to 40 minutes, or 25 to 35 minutes. A vacuum ring may be substituted for the vacuum bag. One type of suitable vacuum bag is disclosed within U.S. Pat No. 3,311,517. Following the heat and pressure cycle, the air in the autoclave is cooled without adding additional gas to maintain pressure in the autoclave. After 20 minutes of cooling, the excess air pressure is vented and the laminates are removed from the autoclave.

Alternatively, the pre-lamination assembly may be heated in an oven at 80°C to 120°C, or 90°C to 100°C, for 20 to 40 minutes, and thereafter, the heated assembly is passed through a set of nip rolls so that the air in the void spaces between the individual layers may be squeezed out, and the edge of the assembly sealed. The assembly at this stage is referred to as a pre-press.

The pre-press may then be placed in an air autoclave where the temperature is raised to 120°C to 160°C, or 135°C to 160°C, at a pressure of 100 to 300 psi (6.9 to 20.7 bar), or 200 psi (13.8 bar). These conditions are maintained for 15 to 60 minutes, or 20 to 50 minutes, and after which, the air is cooled while no more air is added to the autoclave. After 20 to 40 minutes of cooling, the excess air pressure is vented, the laminated products are removed from the autoclave.

The laminates may also be produced through non-autoclave processes. Such non-autoclave processes are disclosed, for example, within U.S. Pat Nos. 3,234,062; 3,852,136; 4,341,576; 4,385,951; 4,398,979; 5,536,347; 5,853,516; 6,342,116; and 5,415,909, U.S. Pat Pub No. 2004/0182493, European Pat No. EP1235683 B1, and PCT Pat Pub Nos. WO91/01880 and WO03/057478 A1. Generally, the non-autoclave processes include heating the pre-lamination assembly and the application of vacuum, pressure or both. For example, the assembly may be successively passed through heating ovens and nip rolls.

This should not be considered limiting. Essentially any lamination process may be used.

### EXAMPLES

The following Examples are intended to be illustrative of the present invention, and are not intended in any way to limit the scope of the present invention.

### Melt Index

Melt Index (MI) is measured by ASTM D1238 at 190°C using a 2160 g load.

### Melting Point

Melting point is measured by differential scanning calorimetry (DSC).

### Lamination Process 1

The component layers of the laminate are stacked to form a pre-lamination assembly. For the assembly containing a polymeric film layer as the outer surface layer, a cover glass sheet is placed over the film layer. The pre-lamination assembly is then placed within a Meier ICOLAM® 10/08 laminator (Meier laminator; Meier Vakuumtechnik GmbH, Bocholt, Germany). The lamination cycle includes an evacuation step (vacuum of 3 in Hg (76 mm Hg)) of 5.5 minutes and a pressing stage (pressure of 1000 mbar) of 5.5 minutes at a temperature of 145°C. The resulting laminate is then removed from the laminator.

### Lamination Process 2

The component layers of the laminate are stacked to form a pre-lamination assembly. For the assembly containing a polymeric film layer as the outer surface layer, a cover glass sheet is placed over the film layer. The pre-lamination assembly is then placed within a vacuum bag, which is sealed and a vacuum is applied to remove the air from the vacuum bag. The bag is placed into an oven and heated to 90°C to 100°C for 30 minutes to remove any air contained between the assembly. The assembly is then subjected to autoclaving at 140°C for 30 minutes in an air autoclave to a pressure of 200 psig (14.3 bar). The air is cooled while no more air is added to the autoclave. After 20 minutes of cooling and when the air temperature reaches less than 50°C, the excess pressure is vented, and the resulting laminate is removed from the autoclave.

### Materials

The following films and sheets are used in the examples:
- AL is a 3.2 mm thick aluminum sheet that is 5052 alloyed with 2.5 wt% of magnesium and conforms to Federal specification QQ-A-250/8 and ASTM B209;
- EBA is a 30 mil (0.76 mm) thick sheet made of a poly(ethylene-con-butyl acrylate) containing, based on the total weight of the polymer, 30 wt% of copolymerized units of n-butyl acrylate and having a MI of 2 g/10 min;
- EVA is SC50B, believed to be a formulated composition based on poly(ethylene-co-vinyl acetate) in the form of a 20 mil thick (0.51 mm) sheet (Hi-Sheet Industries, Japan);
- FPF is a 1.5 mil (0.038 mm) thick corona surface treated Tedlar® film (DuPont);
- Glass 1 is 2.5 mm thick float glass;
- Glass 2 is a 3.0 mm thick clear annealed float glass plate layer;
- Glass 3 is a 3.0 mm thick Solex® solar control glass;
- Glass 4 is Starphire® glass from the PPG Industries, Pittsburgh, PA;
- ION 1 is a 60 mil (1.52 mm) thick embossed sheet made of lonomer A, wherein lonomer A has a MI of approximately 2 g/10 min and is derived from a poly(ethylene-co-methacrylic acid) comprising, based on the total weight of the acid copolymer, 22 wt% copolymerized units of methacrylic acid, and having approximately 27% of its carboxylic acid content neutralized with sodium;
- ION 2 is a 20 mil (0.51 mm) thick embossed sheet of lonomer B, wherein lonomer B has a MI of 2 g/10 min and is derived from a poly(ethylene-co-methacrylic acid) comprising, based on the total weight of the acid copolymer, 19 wt% copolymerized units of methacrylic acid, and having 37% of its carboxylic acid content neutralized with zinc;
- PET 1 is a 7 mils (0.18 mm) thick poly(allyl amine)-primed, biaxially-oriented poly(ethylene terephthalate) film layer;
- PET 2 is a XIR®-70 HP Auto film (Southwall Company, Palo Alto, CA);
- PET 3 is a XIR®-75 Auto Blue V-1 film (Southwall);
- PET 4 is a Soft Look® UV/IR 25 solar control film (Tomoegawa Paper Company, Ltd., Tokyo, Japan);
- PET 5 is a XIR®-75 Green film (Southwall);
- PET 6 is RAYBARRIER® TFK-2583 solar control film (Sumitomo Osaka Cement, Japan);
- PVB-A is a 20 mil thick (0.51 mm) embossed sheet of an acoustic grade of poly(vinyl butyral);
- PVB-B is B51V, believed to be a formulated composition based on poly(vinyl butyral) in the form of a 20 mil thick (0.51 mm) sheet (DuPont);
- Solar Cell 1 is a 10x10 in (254x254 mm) amorphous silicon photovoltaic device comprising a stainless steel substrate (125 µm thick) with an amorphous silicon semiconductor layer (see, e.g., U.S. Pat No. 6,093,581, Example 1);
- Solar Cell 2 is a 10x10 in (254x254 mm) copper indium diselenide (CIS) photovoltaic device (see, e.g., U.S. Pat No. 6,353,042, column 6, line 19);
- Solar Cell 3 is a 10x10 in (254x254 mm) cadmium telluride (CdTe) photovoltaic device (see, e.g., U.S. Pat No. 6,353,042, column 6, line 49);
- Solar Cell 4 is a silicon solar cell made from a 10x10 in (254x254 mm) polycrystalline EFG-grown wafer (see, e.g., U.S. Pat No. 6,660,930, column 7, line 61);
- TI 1 is a 30 mil (0.76 mm) thick embossed sheet of Terionomer A, wherein Terionomer A has a MI of 2.5 g/10 min and is derived from a poly(ethylene-co-n-butylacrylate-co-methacrylic acid) comprising 2 wt% copolymerized units of n-butylacrylate and 19 wt% copolymerized units of methacrylic acid, based on the total weight of the acid terpolymer, and having 40% of its carboxylic acid content neutralized with zinc.
- TI 2 is a 60 mil (1.52 mm) thick embossed tri-layer sheet having two 1 mil (0.03 mm) thick surface layers made of a composition comprising 99.85 wt% of Terionomer B and 0.15 wt% of TINUVIN 328 (Ciba Specialty Chemicals, Tarrytown, NY), based on the total weight of the composition, and an inner layer made of Ionomer A, wherein Terionomer B has a MI of 10 g/10 min and is derived from a poly(ethylene-co-n-butylacrylate-co-methacrylic acid) comprising, based on the total weigh of the acid terpolymer, 4 wt% copolymerized units of n-butylacrylate and 15 wt% copolymerized units of methacrylic acid and having 20% of its carboxylic acids neutralized with zinc and lonomer A has a MI of 1 g/10 min and is derived from a poly(ethylene-co-methacrylic acid) comprising 15 wt% copolymerized units of methacrylic acid, based on the total weight of the acid copolymer, and having 70% of its carboxylic acid content neutralized with sodium.
- TI 3 is a 15 mil (0.38 mm) thick embossed tri-layer sheet having two 1 mil (0.03 mm) thick surface layers made of Terionomer C and an inner layer made of a poly(ethylene-co-n-butyl acrylate) having a MI of 3 g/10 min and comprising 35 wt% copolymerized units of n-butylacrylate, based on the total weight of the polymer, wherein Terionomer C has a MI of 25 g/10 min and is derived from a poly(ethylene-co-n-butylacrylate-co-methacrylic acid) comprising 15 wt% copolymerized units of n-butylacrylate and 22 wt% copolymerized units of methacrylic acid, based on the total weight of the acid terpolymer and having 15% of its carboxylic acid content neutralized with zinc.
- TI 4 is a 90 mil (2.25 mm) thick embossed tri-layer sheet having two 2 mil (0.06 mm) thick surface layers made of Terionomer D and an inner layer made of lonomer B, wherein Terionomer D has a MI of 1 g/10 min and is derived from a poly(ethylene-co-n-butylacrylate-co-methacrylic acid) comprising 20 wt% copolymerized units of n-butylacrylate and 18 wt% copolymerized units of methacrylic acid, based on the total weight of the acid terpolymer, and having 35% of its carboxylic acid content neutralized with zinc and lonomer B has a MI of 1.5 g/10 min and is derived from a poly(ethylene-co-methacrylic acid) comprising 22 wt% copolymerized units of methacrylic acid, based on the total weight of the acid copolymer, and having 35% of its carboxylic acid content neutralized with sodium.
- TI 5 is a 20 mil (0.51 mm) thick embossed bi-layer sheet having a first layer made of Terionomer E and a second layer made of a poly(ethylene-co-methyl acrylate) having a MI of 5 g/10 min and comprising 25 wt% copolymerized units of methyl acrylate, based on the total weight of the polymer, wherein Terionomer E has a MI of 1 g/10 min and is derived from a poly(ethylene-co-n-butylacrylate-co-methacrylic acid) comprising 1 wt% copolymerized units of n-butylacrylate and 23 wt% copolymerized units of methacrylic acid, based on the total weight of the acid terpolymer, and having 30% of its carboxylic acid content neutralized with zinc.
- TI 6 is a 20 mil (0.51 mm) thick embossed sheet made of a composition comprising 99.5 wt% of Terionomer F and 0.5 wt% of CYASORB UV-1164 (Cytec Industries Inc., West Paterson, NJ), based on the total weight of the composition, wherein Terionomer F has a MI of 5 g/10 min and is derived from a poly(ethylene-co-methyl acrylate-co-methacrylic acid) comprising 25 wt% copolymerized units of methyl acrylate and 15 wt% copolymerized units of methacrylic acid, based on the total weight of the acid terpolymer, and having 28% of its carboxylic acid content neutralized with zinc.
- TI 7 is an 1 mil (0.03 mm) thick film made of Terionomer G, wherein Terionomer G has a MI of 15 g/10 min and is derived from a poly(ethylene-co-methyl acrylate-co-methacrylic acid) comprising 5 wt% copolymerized units of methyl acrylate and 18 wt% copolymerized units of methacrylic acid, based on the total weight of the acid terpolymer, and having 20% of its carboxylic acid content neutralized with zinc.
- TI 8 is an 1 mil (0.03 mm) thick film made of Terionomer H, wherein Terionomer H has a MI of 2.5 g/10 min and is derived from a poly(ethylene-co-n-butyl acrylate-co-methacrylic acid) comprising 18 wt% copolymerized units of n-butyl acrylate and 20 wt% copolymerized units of methacrylic acid, based on the total weight of the acid terpolymer, and having 33% of its carboxylic acid content neutralized with zinc.
- TI 9 is an 1 mil (0.03 mm) thick film made of a composition comprising 99.4 wt% of Terionomer C, 0.3 wt% of TINUVIN 1577 and 0.3 wt% of CHIMASSORB 944 (Ciba Specialty Chemicals), based on the total weight of the composition.
- TI 10 is a 20 mil (0.51 mm) thick embossed tri-layer sheet having two 1 mil (0.03 mm) thick surface layers made of Terionomer G and an inner layer made of lonomer A.
- TI 11 is a 20 mil (0.51 mm) thick embossed tri-layer sheet having two 1 mil (0.03 mm) thick surface layers made of Terionomer H and an inner layer made of lonomer B.
- TI 12 is a 20 mil (0.51 mm) thick embossed tri-layer sheet having two 1 mil (0.03 mm) thick surface layers made of Terionomer C and an inner layer made of lonomer A.
- TPT is an Akasol® PTL 3-38/75 film layer (Akasol® film layer; August Krempel Soehne GmbH & Co., Germany) described as a 7 mil thick white poly(vinylidene fluoride)/poly(ethylene terephthalate)/poly(vinylidene fluoride) tri-layer film with primer.

### Examples 1-12

A series of 12x12 in (305x305 mm) laminate structures described below in Table 1 are assembled and laminated by Lamination Process 1. For all examples a terionomer surface of the interlayer is in contact with the tin side of the glass sheet. For Examples 7 and 11, the coated surface of the poly(ethylene terephthalate) film is in contact with the terionomer film or sheet.

### Examples 13-24

A series of 12x12 in (305x305 mm) laminate structures described below in Table 1 are assembled and laminated by Lamination Process 2. For all examples terionomer surface of the interlayer is in contact with the tin side of the glass sheet. For Examples 19 and 23, the coated surface of the poly(ethylene terephthalate) film is in contact with the terionomer film or sheet.

**TABLE 1**

| | Laminate Structures | | | | |
|---|---|---|---|---|---|
| Example | Layer 1 | Layer 2 | Layer 3 | Layer 4 | Laver 5 |
| 1, 13 | Glass 1 | TI1 | Glass 1 | | |
| 2, 14 | Glass 2 | TI 1 | PET 1 | | |
| 3, 15 | Glass 1 | TI 2 | Glass 1 | | |
| 4, 16 | Glass 3 | TI 2 | PET 1 | | |
| 5, 17 | Glass 1 | TI 3 | PET 2 | TI 3 | Glass 1 |
| 6, 18 | Glass 1 | TI 4 | Glass 1 | | |
| 7, 19 | Glass 2 | TI 4 | PET 3 | | |
| 8, 20 | Glass 3 | TI 5 | PET 4 | TI 5 | Glass 1 |
| 9, 21 | Glass 1 | TI 6 | PET 5 | PVB-A | Glass 1 |
| 10, 22 | Glass 1 | TI 7 | ION 1 | TI 7 | Glass 1 |
| 11, 23 | Glass 2 | TI 8 | EBA | TI 8 | PET 6 |
| 12, 24 | Glass 1 | TI 9 | ION 2 | TI 8 | Glass 1 |

### Examples 25-38

A series of 12x12 in (305x305 mm) solar cell laminate structures described below in Table 2 are assembled and laminated by Lamination Process 1. Layers 1 and 2 constitute the incident layer and the front encapsulant layer, respectively, and Layers 4 and 5 constitute the back encapsulant layer and the backing layer, respectively.

### Examples 39-52

A series of 12x12 in (305x305 mm) solar cell laminate structures described below in Table 2 are assembled and laminated by Lamination Process 2. Layers 1 and 2 constitute the incident layer and the front encapsulant layer, respectively, and Layers 4 and 5 constitute the back encapsulant layer and the backing layer, respectively.

**TABLE 2**

| | Laminate Structures | | | | |
|---|---|---|---|---|---|
| Example | Layer 1 | Laver 2 | Layer 3 | Layer 4 | Layer 5 |
| 25, 39 | Glass 4 | TI 3 | Solar Cell 1 | TI 3 | FPF |
| 26, 40 | Glass 4 | TI 3 | Solar Cell 2 | TI 1 | Glass 1 |
| 27, 41 | Glass 4 | TI 5 | Solar Cell 3 | I 5 | TPT |
| 28, 42 | Glass 4 | TI 5 | Solar Cell 4 | TI 2 | Glass 1 |
| 29, 43 | FPF | TI 6 | Solar Cell 1 | I 6 | AL |
| 30, 44 | Glass 4 | EVA | Solar Cell 2 | TI 4 | Glass 1 |
| 31, 45 | FPF | TI 10 | Solar Cell 1 | I 10 | FPF |
| 32, 46 | Glass 1 | TI 10 | Solar Cell 2 | PVB | PET 1 |
| 33, 47 | Glass 4 | TI 11 | Solar Cell 3 | TI 11 | TPT |
| 34, 48 | Glass 4 | TI 11 | Solar Cell 4 | ION 2 | AL |
| 35, 49 | Glass 4 | ION 2 | Solar Cell 1 | TI 11 | Glass 1 |
| 36, 50 | Glass 4 | TI 12 | Solar Cell 2 | TI 12 | FPF |
| 37, 51 | Glass 4 | TI 12 | Solar Cell 1 | PVB-A | Glass 1 |
| 38, 52 | Glass 4 | TI 12 | Solar Cell 4 | ION 1 | |

## Claims

1. A solar cell pre-lamination assembly comprising a solar cell component and a film or sheet wherein
the solar cell component comprises or is formed of one or a plurality of electronically interconnected solar cells;
the solar cell component has a light-receiving side that faces a light source and a back side that is opposite from the light source;
the film or sheet is made of a terionomer composition;
the terionomer is derived from an acid terpolymer that is 5% to 90% of its carboxylic acid content neutralized with one or more metal ions and comprises copolymerized units derived from an α-olefin, 18 to 25 wt% of an α,β-ethylenically unsaturated carboxylic acid having 3 to 8 carbons, and 0.5 to 40 wt% of an α,β-ethylenically unsaturated carboxylic acid ester having 4 to 12 carbons, based on the total weight of the acid terpolymer, wherein the film or sheet is a single layer.

2. The assembly of claim 1 wherein the acid terpolymer comprises 0.5 to 5 wt%, or 15 to 40 wt%, of copolymerized units of the α,β-ethylenically unsaturated carboxylic acid ester and has 10% to 50%, preferably 20% to 40%, of its carboxylic acid content neutralized.

3. The assembly of claim 1 or 2 wherein the terionomer is derived from poly(ethylene-co-butyl acrylate-co-methacrylic acid) having 20% to 40% of its carboxylic acid content neutralized with sodium ion, lithium ion, magnesium ion, zinc ion, and mixtures of two of more thereof.

4. The assembly of claim 1, 2, or 3 wherein the film or sheet has a total thickness of 0.051 mm to 0.51 mm.

5. The assembly of claim 1, 2, 3, or 4 comprising a front encapsulant layer positioned next to the light-receiving side of the solar cell component and a back encapsulant layer positioned next to the back side of the solar cell component wherein
the front encapsulant layer is formed of the film or sheet;
the back encapsulant layer is formed of acid copolymer, ionomer, ethylene vinyl acetate, poly(vinyl acetal), polyurethane, polyvinylchloride, polyethylene, polyolefin block elastomer, poly(α-olefin-co-α,β-ethylenically unsaturated carboxylic acid ester) copolymer, silicone elastomer, epoxy resin, or combinations of two or more thereof; and
the poly(vinyl acetal) preferably includes acoustic grade poly(vinyl acetal).

6. The assembly of claim 5 wherein each of the front encapsulant layer and the back encapsulant layer comprises or is formed of the film or sheet.

7. The assembly of claim 5 or 6 further comprising an incident layer positioned next to the front encapsulant layer and a backing layer positioned to the back encapsulant layer wherein the incident layer is (i) glass sheet, (ii) polymeric sheet formed of polycarbonate, acrylic, polyacrylate, cyclic polyolefin, polystyrene, polyamide, polyester, fluoropolymer, or combinations of two or more thereof, or (iii) polymeric film formed of polyester, polycarbonate, polyolefin, norbornene polymer, polystyrene, styrene-acrylate copolymer, acrylonitrile-styrene copolymer, polysulfone, nylon, polyurethane, acrylic, cellulose acetate, cellophane, poly(vinyl chloride), fluoropolymer, or combinations of two or more thereof.

8. The assembly of claim 5, 6, or 7 wherein
the backing layer is (i) glass sheet, (ii) polymeric sheet, (iii) polymeric film, (iv) metal sheet, or (v) ceramic plate;
the polymeric sheet comprises or is formed of polycarbonate, acrylics, polyacrylate, cyclic polyolefin, polystyrene, polyamide, polyester, fluoropolymer, or combinations or two or more thereof; and
the polymeric film comprises or is formed of polyester, polycarbonate, polyolefin, norbornene polymer, polystyrene, styrene-acrylate copolymer, acrylonitrile-styrene copolymer, polysulfone, nylon, polyurethane, acrylic, cellulose acetate, cellophanes, poly(vinyl chloride), fluoropolymer, or combinations of two or more thereof.

9. The assembly of claim 1, 2, 3, or 4 consisting essentially of, from a top side that faces the light source to a bottom side that is opposite from the light source, (i) an incident layer that is positioned next to, (ii) a front encapsulant layer that is positioned next to, (iii) the solar cell component that is positioned next to, (iv) a back encapsulant layer that is positioned next to, (v) a backing layer, wherein the front encapsulant layer or the back encapsulant layers, or both, is formed of the terionomer film or sheet.

10. A process comprising: (i) providing a solar cell pre-lamination assembly and (ii) laminating the assembly to form a solar cell module, wherein the assembly is as **characterized in** any one of claims 1 to 9 and the laminating is preferably conducted by subjecting the assembly to heat.

11. The process of claim 10 wherein the laminating further comprises subjecting the assembly to vacuum or pressure.

12. A solar cell module comprising a solar cell pre-lamination assembly, wherein the assembly is as **characterized in** any one of claims 1 to 9 and, preferably, after the module has been conditioned for 1000 hours at a temperature of 85°C and a relative humidity of 85%, at least 75% of the 180° peel strength between the terionomer film or sheet and its adjacent layer(s) is maintained.

## Patentansprüche

1. Eine Solarzellenvorlaminierungsanordnung, beinhaltend eine Solarzellenkomponente und eine Folie oder Platte, wobei
die Solarzellenkomponente eine oder eine Vielzahl elektronisch verschalteter Solarzellen beinhaltet oder daraus gebildet ist;
die Solarzellenkomponente eine lichtempfangende Seite, die einer Lichtquelle zugewandt ist, und eine hintere Seite, die von der Lichtquelle abgewandt ist, aufweist; die Folie oder Platte aus einer Terionomerzusammensetzung hergestellt ist;
das Terionomer von einem Säureterpolymer abgeleitet ist, dessen Carbonsäuregehalt zu 5 % bis 90 % mit einem oder mehreren Metallionen neutralisiert ist und das copolymerisierte Einheiten eines α-Olefins, zu 18 bis 25 Gew.-% einer α,β-ethylenisch ungesättigten Carbonsäure mit 3 bis 8 Kohlenstoffen und zu 0,5 bis 40 Gew.-% eines α,β-ethylenisch ungesättigten Carbonsäureesters mit 4 bis 12 Kohlenstoffatomen, bezogen auf das Gesamtgewicht des Säureterpolymers, beinhaltet, wobei die Folie oder Platte eine einzelne Schicht ist.

2. Anordnung gemäß Anspruch 1, wobei das Säureterpolymer zu 0,5 bis 5 Gew.-% oder zu 15 bis 40 Gew.-% copolymerisierte Einheiten des α,β-ethylenisch ungesättigten Carbonsäureesters beinhaltet und sein Carbonsäuregehalt zu 10 % bis 50 %, vorzugsweise zu 20 % bis 40 %, neutralisiert ist.

3. Anordnung gemäß Anspruch 1 oder 2, wobei das Terionomer von Poly(ethylen-co-butylacrylat-co-methacrylsäure) abgeleitet ist, wobei sein Carbonsäuregehalt zu 20 % bis 40 % mit Natriumion, Lithiumion, Magnesiumion, Zinkion und Mischungen von zwei oder mehr davon neutralisiert ist.

4. Anordnung gemäß Anspruch 1, 2 oder 3, wobei die Folie oder Platte eine Gesamtdicke von 0,051 mm bis 0,51 mm aufweist.

5. Anordnung gemäß Anspruch 1, 2, 3 oder 4, beinhaltend eine vordere Verkapselungsschicht, die neben der lichtempfangenden Seite der Solarzellenkomponente positioniert ist, und eine hintere Verkapselungsschicht, die neben der hinteren Seite der Solarzellenkomponente positioniert ist, wobei
die vordere Verkapselungsschicht aus der Folie oder Platte gebildet ist;
die hintere Verkapselungsschicht aus Säurecopolymer, lonomer, Ethylenvinylacetat, Poly(vinylacetal), Polyurethan, Polyvinylchlorid, Polyethylen, Polyolefinblockelastomer, Poly(α-olefin-co-α,β-ethylenisch ungesättigtem Carbonsäureester)-Copolymer, Silikonelastomer, Epoxidharz oder Kombinationen von zwei oder mehr davon gebildet ist; und
das Poly(vinylacetal) vorzugsweise Poly(vinylacetal) akustischer Güteklasse umfasst.

6. Anordnung gemäß Anspruch 5, wobei jede der vorderen Verkapselungsschicht und der hinteren Verkapselungsschicht die Folie oder Platte beinhaltet oder daraus gebildet ist.

7. Anordnung gemäß Anspruch 5 oder 6, ferner beinhaltend eine neben der vorderen Verkapselungsschicht positionierte Auftreffschicht und eine neben der hinteren Verkapselungsschicht positionierte Trägerschicht, wobei die Auftreffschicht (i) Glasplatte, (ii) aus Polycarbonat, Acryl, Polyacrylat, zyklischem Polyolefin, Polystyrol, Polyamid, Polyester, Fluorpolymer oder Kombinationen von zwei oder mehr davon gebildete Polymerplatte oder (iii) aus Polyester, Polycarbonat, Polyolefin, Norbornenpolymer, Polystyrol, Styrol-Acrylat-Copolymer, Acrylnitril-Styrol-Copolymer, Polysulfon, Nylon, Polyurethan, Acryl, Celluloseacetat, Cellophan, Poly(vinylchlorid), Fluorpolymer oder Kombinationen von zwei oder mehr davon gebildete Polymerfolie ist.

8. Anordnung gemäß Anspruch 5, 6 oder 7, wobei
die Trägerschicht (i) Glasplatte, (ii) Polymerplatte, (iii) Polymerfolie, (iv) Metallplatte oder (v) Keramiktafel ist;
die Polymerplatte Polycarbonat, Acryle, Polyacrylat, zyklisches Polyolefin, Polystyrol, Polyamid, Polyester, Fluorpolymer oder Kombinationen von zwei oder mehr davon beinhaltet oder daraus gebildet ist; und
die Polymerfolie Polyester, Polycarbonat, Polyolefin, Norbornenpolymer, Polystyrol, Styrol-Acrylat-Copolymer, Acrylnitril-Styrol-Copolymer, Polysulfon, Nylon, Polyurethan, Acryl, Celluloseacetat, Cellophane, Poly(vinylchlorid), Fluorpolymer oder Kombinationen von zwei oder mehr davon beinhaltet oder daraus gebildet ist.

9. Anordnung gemäß Anspruch 1, 2, 3 oder 4, im Wesentlichen bestehend, von einer oberen Seite, die der Lichtquelle zugewandt ist, zu einer unteren Seite, die von der Lichtquelle abgewandt ist, aus (i) einer Auftreffschicht, positioniert neben (ii) einer vorderen Verkapselungsschicht, positioniert neben (iii) der Solarzellenkomponente, positioniert neben (iv) einer hinteren Verkapselungsschicht, positioniert neben (v) einer Trägerschicht, wobei die vordere Verkapselungsschicht oder die hintere Verkapselungsschicht oder beide aus der Terionomerfolie oder -platte gebildet ist/sind.

10. Ein Verfahren, beinhaltend: (i) Bereitstellen einer Solarzellenvorlaminierungsanordnung und (ii) Laminieren der Anordnung, um ein Solarzellenmodul zu bilden, wobei die Anordnung wie in einem der Ansprüche 1 bis 9 gekennzeichnet ist und das Laminieren vorzugsweise durch Unterziehen der Anordnung gegenüber Wärme durchgeführt wird.

11. Verfahren gemäß Anspruch 10, wobei das Laminieren ferner das Unterziehen der Anordnung gegenüber Vakuum oder Druck beinhaltet.

12. Ein Solarzellenmodul, beinhaltend eine Solarzellenvorlaminierungsanordnung, wobei die Anordnung wie in einem der Ansprüche 1 bis 9 gekennzeichnet ist und, nachdem das Modul für 1000 Stunden bei einer Temperatur von 85 °C und einer relativen Luftfeuchtigkeit von 85 % konditioniert worden ist, vorzugsweise mindestens 75 % der 180°-Abziehfestigkeit zwischen der Terionomerfolie oder -platte und der angrenzenden Schicht(en) derselben beibehalten werden.

## Revendications

1. Un ensemble de préstratification de cellule solaire comprenant un composant de cellule solaire et un film ou une feuille dans lequel
le composant de cellule solaire comprend ou est formé d'une ou d'une pluralité de cellules solaires interconnectées électroniquement ;
le composant de cellule solaire a un côté récepteur de lumière qui fait face à une source lumineuse et un côté arrière qui est à l'opposé de la source lumineuse ;
le film ou la feuille est réalisé en une composition de terionomère ;
le terionomère est dérivé d'un terpolymère d'acide qui a de 5 % à 90 % de sa teneur en acide carboxylique neutralisée par un ou plusieurs ions métalliques et comprend des unités copolymérisées dérivées d'une α-oléfine, de 18 à 25 % en poids d'un acide carboxylique α,β-éthyléniquement insaturé ayant de 3 à 8 carbones, et de 0,5 à 40 % en poids d'un ester d'acide carboxylique α,β-éthyléniquement insaturé ayant de 4 à 12 carbones, rapporté au poids total du terpolymère d'acide, dans lequel le film ou la feuille est une couche unique.

2. L'ensemble de la revendication 1 dans lequel le terpolymère d'acide comprend de 0,5 à 5 % en poids, ou de 15 à 40 % en poids, d'unités copolymérisées d'ester d'acide carboxylique α,β-éthyléniquement insaturé et a de 10 % à 50 %, de préférence de 20 % à 40 %, de sa teneur en acide carboxylique neutralisée.

3. L'ensemble de la revendication 1 ou de la revendication 2 dans lequel le terionomère est dérivé du poly(éthylène-co-acrylate de butyle-co-acide méthacrylique) ayant de 20 % à 40 % de sa teneur en acide carboxylique neutralisée par un ion sodium, un ion lithium, un ion magnésium, un ion zinc, et des mélanges de deux ou plus de ceux-ci.

4. L'ensemble de la revendication 1, de la revendication 2, ou de la revendication 3 dans lequel le film ou la feuille a une épaisseur totale de 0,051 mm à 0,51 mm.

5. L'ensemble de la revendication 1, de la revendication 2, de la revendication 3, ou de la revendication 4 comprenant une couche d'agent d'encapsulation avant positionnée auprès du côté récepteur de lumière du composant de cellule solaire et une couche d'agent d'encapsulation arrière positionnée auprès du côté arrière du composant de cellule solaire dans lequel
la couche d'agent d'encapsulation avant est formée du film ou de la feuille ;
la couche d'agent d'encapsulation arrière est formée de copolymère d'acide, d'ionomère, d'éthylène acétate de vinyle, de poly(vinyl acétale), de polyuréthane, de polychlorure de vinyle, de polyéthylène, d'élastomère séquencé de polyoléfine, de copolymère poly(α-oléfine-co-ester d'acide carboxylique α,β-éthyléniquement insaturé), d'élastomère de silicone, de résine époxy, ou de combinaisons de deux ou plus de ceux-ci ; et
le poly(vinyl acétale) inclut de préférence du poly(vinyl acétale) de classe acoustique.

6. L'ensemble de la revendication 5 dans lequel chacune des couches parmi la couche d'agent d'encapsulation avant et la couche d'agent d'encapsulation arrière comprend ou est formée du film ou de la feuille.

7. L'ensemble de la revendication 5 ou de la revendication 6 comprenant en outre une couche incidente positionnée auprès de la couche d'agent d'encapsulation avant et une couche de support positionnée au niveau de la couche d'agent d'encapsulation arrière dans lequel la couche incidente est (i) une feuille de verre, (ii) une feuille polymère formée de polycarbonate, d'acrylique, de polyacrylate, de polyoléfine cyclique, de polystyrène, de polyamide, de polyester, de fluoropolymère, ou de combinaisons de deux ou plus de ceux-ci, ou (iii) un film polymère formé de polyester, de polycarbonate, de polyoléfine, de polymère de norbornène, de polystyrène, de copolymère styrène-acrylate, de copolymère d'acrylonitrile-styrène, de polysulfone, de nylon, de polyuréthane, d'acrylique, d'acétate de cellulose, de cellophane, de poly(chlorure de vinyle), de fluoropolymère, ou de combinaisons de deux ou plus de ceux-ci.

8. L'ensemble de la revendication 5, de la revendication 6, ou de la revendication 7 dans lequel
la couche de support est (i) une feuille de verre, (ii) une feuille polymère, (iii) un film polymère, (iv) une feuille de métal, ou (v) une plaque de céramique ;
la feuille polymère comprend ou est formée de polycarbonate, d'acryliques, de polyacrylate, de polyoléfine cyclique, de polystyrène, de polyamide, de polyester, de fluoropolymère, ou de combinaisons de deux ou plus de ceux-ci ; et
le film polymère comprend ou est formé de polyester, de polycarbonate, de polyoléfine, de polymère de norbornène, de polystyrène, de copolymère de styrène-acrylate, de copolymère d'acrylonitrile-styrène, de polysulfone, de nylon, de polyuréthane, d'acrylique, d'acétate de cellulose, de cellophanes, de poly(chlorure de vinyle), de fluoropolymère, ou de combinaisons de deux ou plus de ceux-ci.

9. L'ensemble de la revendication 1, de la revendication 2, de la revendication 3, ou de la revendication 4 constitué essentiellement, à partir d'un côté de dessus qui fait face à la source lumineuse jusqu'à un côté de dessous qui est à l'opposé de la source lumineuse, (i) d'une couche incidente qui est positionnée auprès, (ii) d'une couche d'agent d'encapsulation avant qui est positionnée auprès, (iii) du composant de cellule solaire qui est positionné auprès, (iv) d'une couche d'agent d'encapsulation arrière qui est positionnée auprès, (v) d'une couche de support, dans lequel la couche d'agent d'encapsulation avant ou la couche d'agent d'encapsulation arrière, ou les deux, est formée du film ou de la feuille de terionomère.

10. Un procédé comprenant : (i) la fourniture d'un ensemble de préstratification de cellule solaire et (ii) la stratification de l'ensemble afin de former un module de cellule solaire, l'ensemble étant tel que caractérisé dans l'une quelconque des revendications 1 à 9 et la stratification étant de préférence effectuée en soumettant l'ensemble à de la chaleur.

11. Le procédé de la revendication 10 dans lequel la stratification comprend en outre le fait de soumettre l'ensemble à du vide ou à de la pression.

12. Un module de cellule solaire comprenant un ensemble de préstratification de cellule solaire, dans lequel l'ensemble est tel que caractérisé dans l'une quelconque des revendications 1 à 9 et, de préférence, après que le module a été conditionné pendant 1 000 heures à une température de 85 °C et à une humidité relative de 85 %, au moins 75 % de la résistance au pelage à 180° entre le film ou la feuille de terionomère et sa(ses) couche(s) adjacente(s) est maintenue.
